# EUROPÄISCHE PATENTSCHRIFT

(11) **EP 2 828 588 B1**
(45) Veröffentlichungstag und Bekanntmachung des Hinweises auf die Patenterteilung: **11.12.2019**
(21) Anmeldenummer: 12784444.7
(22) Anmeldetag: 19.10.2012
(51) Int. Cl.: F24S 25/613, F24S 25/70

(54) **SOLARMODULHALTER**
SOLAR MODULE BRACKET
SYSTÈME DE FIXATION POUR MODULE SOLAIRE

(30) Priorität: 19.03.2012 DE 102012005320; 12.06.2012 DE 102012011969
(43) Veröffentlichungstag der Anmeldung: 28.01.2015
(73) Patentinhaber: K2 Systems GmbH, 71272 Renningen (DE)
(72) Erfinder: KRANNICH, Kurt, 71263 Weil der Stadt/Hausen (DE); SCHÜTZ, Veit, 70197 Stuttgart (DE)
(74) Vertreter: Clarenbach, Carl-Philipp
(86) Internationale Anmeldenummer: PCT/EP2012/004401
(87) Internationale Veröffentlichungsnummer: WO 2013/139357

(56) Entgegenhaltungen:
- EP-A1- 2 093 524
- EP-A1- 2 194 335
- EP-A1- 2 360 740
- EP-A2- 2 333 452
- DE-A1-102005 058 065
- DE-U1-202005 004 348
- US-A- 4 656 794

## Beschreibung

Die Erfindung betrifft einen Solarmodulhalter mit einem insbesondere an einem Dach befestigbaren Grundträger und einem Bügelträger zum Halten einer Modultragschiene, wobei der Bügelträger einen Befestigungsbereich aufweist, der mit dem Grundträger lösbar verbunden ist.

Ein derartiger Solarmodulhalter ist aus der DE 102 13 902 A1 bekannt. Er dient dazu, Solarmodule auf einem Dach eines Gebäudes zu befestigen. Hierzu wird der Grundträger an einer Dachkonstruktion, beispielsweise an einem Dachsparren, befestigt. Der an dem Grundträger lösbar befestigte Bügelträger umgreift aufgrund seiner gebogenen Form eine Dacheindeckung, beispielsweise eine Dachpfanne, sodass sein freier Endbereich oberhalb der Dacheindeckung liegt und dort eine Modultragschiene halten kann, an der mindestens ein Solarmodul befestigt wird. Da das Solarmodul der Witterung ausgesetzt ist, wird es beispielsweise im Winter mit einer Schneelast belegt oder bei Sturm mit Windkraft beaufschlagt. Der bekannte Solarmodulhalter ist aufgrund seiner Konstruktion weniger geeignet, dem Wechselspiel der unterschiedlichen Krafteinflüsse auf lange Zeit hinreichend standzuhalten.

Aus der Offenlegungsschrift EP 2 194 335 A1 ist ein weiterer Solarmodulhalter bekannt, der einen lösbar an dem Grundträger befestigbaren Bügelträger aufweist, wobei der Bügelträger einen in zwei Arme übergehenden Verzweigungsbereich aufweist, wobei die Arme einen Abschnitt des Grundträgers zur Befestigung zwischen sich aufnehmen. Aus der Offenlegungsschrift EP 2 093 524 A1 ist des Weiteren ein Solarmodulhalter bekannt, der mit einem freien Endabschnitt in eine Aufnahmenut eines Grundhalters eingreift.

Der Erfindung liegt daher die Aufgabe zugrunde, einen Solarmodulhalter anzugeben, der eine einfache Konstruktion aufweist, kostengünstig herzustellen ist und eine hohe Stabilität besitzt. Insbesondere soll er darüber hinaus geeignet sein, Längenänderungen aufgrund von Temperaturschwankungen auszugleichen.

Diese Aufgabe wird erfindungsgemäß durch einen Solarmodulhalter mit den Merkmalen des Anspruchs 1 dadurch gelöst, dass der Befestigungsbereich von einem mehrere Arme aufweisenden Bügelabschnitt des Bügelträgers gebildet ist, wobei jeder Arm des Bügelabschnitts mit dem Grundträger lösbar verbunden ist. Erfindungsgemäß wird eine von dem Bügelträger an den Grundträger abzuleitende Belastung somit über mehrere Arme abgeführt, sodass jeder Arm nur eine Teilkraft aufnehmen muss, wodurch sich eine sehr stabile Konstruktion des Solarmodulhalters ergibt. Ferner verhindern mehrere Arme ein unzulässiges Verkippen des Bügelträgers, da aufgrund der beabstandet zueinander liegenden Arme beabstandet zueinander liegende Stützpunkte geschaffen sind.

Nach einer Weiterbildung der Erfindung ist vorgesehen, dass der Befestigungsbereich einem ersten Endbereich des Bügelträgers angehört. Die Befestigung des Bügelträgers an dem Grundträger erfolgt somit in diesem ersten Endbereich.

Ferner ist es erfindungsgemäß, wenn der Bügelträger einen Bügelmittelbereich aufweist, der einstückig in einen Verzweigungsbereich übergeht, der wiederum einstückig in die Arme übergeht. Der Bügelmittelbereich ist bogenförmig, insbesondere etwa U-förmig gestaltet, um die Dacheindeckung, beispielsweise die genannte Dachpfanne, zu umgreifen. Dieser U-förmige Bügelmittelbereich geht einstückig in den genannten Verzweigungsbereich über, der die gemeinsame Wurzel für die von dort ausgehenden Arme bildet, die einstückig mit dem Verzweigungsbereich verbunden sind. Insgesamt liegt daher Einstückigkeit zwischen dem Bügelmittelbereich und den Armen vor.

Erfindungsgemäß sind zwei Arme (genau zwei Arme) vorgesehen, was dazu führt, dass der Verzweigungsbereich als V-Verzweigungsbereich gestaltet ist.

Ferner ist es vorteilhaft, wenn die Längserstreckungen der Arme zumindest abschnittsweise einen spitzen Winkel einschließen. Vom Verzweigungsbereich ausgehend bilden die Arme zueinander den genannten spitzen Winkel aus, was dazu führt, dass die freien Enden der Arme voneinander beabstandet liegen und somit eine große und sichere Standfläche aufspannen.

Eine Weiterbildung der Erfindung sieht vor, dass zumindest einer der Arme ein Winkelarm ist. Aufgrund des Winkelarms kann dessen zum freien Ende gehörender Armabschnitt eine Parallelstellung zum anderen, nicht gewinkelten Arm einnehmen, sodass die Befestigung der beiden Arme am Grundträger gleichartig ausgebildet sein kann.

Die Erfindung sieht vor, dass die freien Enden der Arme über Nutsteinverbindungen mit dem Grundträger verbunden sind. Die freien Enden der Arme weisen Nutsteine auf und der Grundträger ist mit Aufnahmenuten, insbesondere C-Profilnuten, versehen. Durch einfaches Einschieben der Nutsteine in die C-Profilnuten, lässt sich daher der Bügelträger am Grundträger lösbar halten.

Erfindungsgemäß ist der Grundträger als Grundplatte ausgebildet, sodass eine flache, jedoch hinsichtlich der Grundfläche hinreichend große Konstruktion vorliegt. Alternativ weist der Grundträger bevorzugt eine Grundplatte auf, auf der beispielsweise Mittel angeordnet sind, die der Verbindung der Arme mit dem Grundträger dienen.

Eine Weiterbildung der Erfindung sieht vor, dass der Grundträger mindestens ein Befestigungsloch aufweist, das zwischen den Armen liegt. Um den Grundträger beispielsweise an dem erwähnten Dach des Gebäudes zu befestigen, wird ein Befestigungselement, insbesondere eine Edelstahl-Holzbauschraube, in das Befestigungsloch eingesteckt und dann beispielsweise in den Dachsparren eingeschraubt. Da das erwähnte Befestigungsloch zwischen den Armen liegt, ist eine hohe Stabilität gewährleistet, da das Befestigungselement nahe der Arme, nämlich sogar zwischen den Armen, liegt. Bevorzugt sind mehrere Befestigungslöcher im Grundträger vorgesehen, um weitere Befestigungselemente einsetzen zu können, wobei diese weiteren Befestigungslöcher ebenfalls zumindest teilweise zwischen den Armen und/oder auch außerhalb des zwischen den Armen liegenden Bereichs des Grundträgers liegen können, um eine Variabilität der Befestigungs- beziehungsweise Anschraubposition der Grundplatte an zum Beispiel einem Sparren, einer Pfette, einer Latte und so weiter zu ermöglichen. Gemäß einer alternativen bevorzugten Ausführungsform liegt mindestens ein Befestigungsloch außerhalb eines zwischen den Armen liegenden Bereichs des Grundträgers, um eine gute Kraftableitung und/oder einfache Montage des Grundträgers zu ermöglichen.

Eine Weiterbildung der Erfindung sieht vor, dass der Bügelträger eine Bügelmittelebene aufspannt, wobei die Arme in der Bügelmittelebene liegen. Aufgrund seiner gebogenen Form, insbesondere U-Form, spannt der Bügelträger die erwähnte Bügelmittelebene auf. In derselben Ebene liegen auch die Arme. Dies bedeutet, dass alle beziehungsweise beide Arme in dieser (derselben) Ebene liegen und nicht etwa eine Konstruktion vorliegt, bei der ein Arm rechts der genannten Bügelmittelebene liegt und der andere Arm links von dieser Ebene.

Es ist vorteilhaft, wenn der Bügelträger eine Bügelbreite aufweist, die über den gesamten Bügelträgerlängsverlauf konstant oder etwa konstant ist. Demzufolge sind Bügelmittelbereich, Verzweigungsbereich und die Arme gleich breit oder etwa gleich breit ausgebildet. Es ist insbesondere vorgesehen, dass der Bügelträger als Strangpressbauteil hergestellt wird, dass nach der Strangpressung lediglich in "Scheiben" geschnitten wird, wobei die Scheibendicke der erwähnten Bügelbreite entspricht.

Es ist vorteilhaft, wenn der Bügelträger einen Modulhaltebereich aufweist, der einen zweiten Endbereich des Bügelträgers bildet. In diesem zweiten Endbereich ist die Modultragschiene befestigt. Zum Befestigen dient - nach einer Weiterbildung der Erfindung - ein Klemmhalter. Dies bedeutet, dass die Modultragschiene durch Klemmung an dem Bügelträger gehalten ist.

Es ist vorteilhaft, wenn zumindest einer der Arme geradlinig verläuft und rechtwinklig zu der Ebene der Grundplatte steht. Bevorzugt ist dabei vorgesehen, dass der Winkelarm einen Armabschnitt aufweist, der rechtwinklig zur Ebene der Grundplatte steht. Insbesondere kann dabei vorgesehen sein, dass der Armabschnitt über eine der Nutsteinverbindungen mit dem Grundträger verbunden ist. Aufgrund der vorstehenden Ausgestaltung ergibt sich eine sehr stabile Befestigung des Bügelträgers an dem Grundträger.

Nach einer Weiterbildung der Erfindung ist vorgesehen, dass der Bügelmittelbereich eine Abbiegung aufweist, an die der Verzweigungsbereich unmittelbar anschließt. Hierdurch wird eine flache Konstruktion des Solarmodulhalters erzielt, um die erwähnte Dachpfanne untergreifen zu können.

Schließlich ist es vorteilhaft, wenn die Nutsteinverbindungen als Verschiebeverbindungen ausgebildet sind. Dies bedeutet, dass sie nicht - zum Beispiel mit Klemmmitteln - fixiert sind, sondern dass sich Nutsteine in Aufnahmenuten, insbesondere C-Profilnuten, in Nutlängsrichtung verlagern können, um so Temperaturausdehnungen ausgleichen zu können. Dies verhindert den Aufbau von Materialspannungen.

Vorzugsweise sind stets mehrere Solarmodulhalter vorgesehen, um eine Modultragschiene zu halten, wobei dann zumindest bei einem der Solarmodulhalter eine Anschlagvorrichtung vorgesehen ist, die verhindert, dass der Bügelträger dieses Solarmodulhalters aus dem zugehörigen Grundträger herausrutschen kann.

Erfindungsgemäß ist vorgesehen, dass die Nutsteinverbindungen jeweils einen am freien Ende des jeweiligen Arms vorgesehenen Nutstein und mindestens eine am Grundträger vorgesehene Aufnahme, nämlich Aufnahmenut, für den Nutstein aufweisen. Insbesondere weist die Aufnahmenut eine Längserstreckung auf, entlang der der Nutstein in die Aufnahmenut einschiebbar und in der Aufnahmenut verschiebbar angeordnet ist. Durch die Nutsteinverbindungen ist also eine Hintergriffsverbindung zwischen dem Bügelträger und dem Grundträger geschaffen. Dabei handelt es sich um eine einfache und flexible Verbindung, da die Nutsteine zur Anpassung an die örtlichen Gegebenheiten in den Aufnahmenuten verschoben werden können, um eine gewünschte Positionierung des Bügelhalters relativ zum Grundträger einzustellen. Durch diese verschiebbare Verbindung werden ferner Wärmespannungen vermieden.

Es ist vorzugsweise vorgesehen, dass der Nutstein als L-Nutstein oder T-Nutstein ausgebildet ist. Unter einem L-Nutstein ist ein L-förmiger Nutstein zu verstehen, das heißt, das freie Ende des zugehörigen Arms ist "abgeknickt" ausgebildet, sodass insgesamt der Endbereich des Arms eine L-Form aufweist. Entsprechend ist unter einem T-Nutstein ein T-förmiger Nutstein zu verstehen, das heißt, der Endbereich des zugehörigen Arms weist eine T-Form auf.

Es ist vorteilhaft, wenn die Aufnahmenut als Einschiebeaufnahmenut oder Einhakaufnahmenut ausgebildet ist. Unter einer Einschiebeaufnahmenut ist eine Aufnahmenut zu verstehen, in die der zugehörige Nutstein durch Einschieben in Richtung der Längserstreckung der Aufnahmenut eingebracht werden kann. Ein Einbringen des Nutsteins in die Einschiebeaufnahmenut durch deren Längsöffnung ist aufgrund der Dimensionierung der Längsöffnung und des Nutsteins nicht möglich. Insbesondere ist die Breite der Längsöffnung kleiner als die Breite des Nutsteins. Unter einer Einhakaufnahmenut ist eine Aufnahmenut zu verstehen, deren Längsöffnung derart dimensioniert ist, dass ein Einbringen des zugehörigen Nutsteins in die Aufnahmenut durch deren Längsöffnung möglich ist, wodurch die Montage erleichtert werden kann. Insbesondere ist die Breite der Längsöffnung größer als die Breite des Nutsteins. Um bei der Montage einen Hintergriff von Nutstein und Einhakaufnahmenut zu erreichen, ist zunächst ein Einstecken des Nutsteins in die Längsöffnung der Aufnahmenut erforderlich. Dies erfolgt quer zur Längserstreckung der Aufnahmenut. Dann ist ein Verlagern des Nutsteins in der Aufnahmenut erforderlich. Das Verlagern erfolgt quer zur Einsteckbewegung sowie quer zur Längserstreckung der Aufnahmenut. Dadurch ist insgesamt ein Hintergriff des Nutsteins zur Einhakaufnahmenut gewährleistet. Es wird also der Bügelträger durch Einhaken des Nutsteins in die Einhakaufnahmenut mit dem Grundträger verbunden beziehungsweise durch Aushaken von diesem getrennt. Natürlich kann der Nutstein auch durch Einschieben (in Richtung der Längserstreckung der Einhakaufnahmenut) in die Einhakaufnahmenut eingebracht beziehungsweise aus dieser entnommen werden.

Erfindungsgemäß ist vorgesehen, dass für jeden Nutstein mehrere Aufnahmenuten am Grundträger vorgesehen sind, die unterschiedliche Höhenabstände zur Ebene der Grundplatte aufweisen. Aufgrund der mehreren Aufnahmenuten pro Nutstein wird eine Höhenverstellbarkeit des Bügelträgers relativ zum Grundträger und insbesondere zum Dach, an dem der Grundträger befestigt ist, erzielt. Daher lässt sich der Solarmodulhalter an die spezifischen Gegebenheiten des Dachs anpassen, um stets sicherzustellen, dass die Dacheindeckung von dem Bügelträger umgriffen werden kann. Auch lässt sich der Solarmodulhalter aufgrund dieser Ausbildung vielseitig, insbesondere an verschiedenen Arten von Dachkonstruktionen und Dacheindeckungen einsetzen.

Eine Weiterbildung der Erfindung sieht vor, dass die mehreren Aufnahmenuten übereinander angeordnet an einer an der Grundplatte vorgesehenen Halterung vorgesehen sind. Durch die Halterung und/oder die Halterung in Kombination mit der Grundplatte sind die Aufnahmenuten für die mindestens zwei Nutsteine ausgebildet. Vorzugsweise ist der Grundträger mit der Grundplatte und der Halterung einstückig, insbesondere als Strangpressbauteil ausgebildet.

Gemäß einer bevorzugten Weiterbildung der Erfindung ist vorgesehen, dass die Halterung zwei rechtwinklig von der Grundplatte wegragende, zueinander parallele Längswände mit jeweils mehreren Querwänden aufweist, wobei zwischen der Grundplatte und zwei der Querwände sowie zwischen den weiteren Querwänden die Aufnahmenuten ausgebildet sind. Von jeder der Längswände ragen die Querwände bevorzugt rechtwinklig weg, sodass die Querwände parallel zur Grundplatte und parallel zueinander verlaufen. Der Abstand zwischen der Grundplatte und den benachbarten Querwänden sowie der Abstand zwischen benachbarten Querwänden ist vorzugsweise gleich groß, sodass identische Aufnahmenuten ausgebildet sind.

Insbesondere ist vorgesehen, dass zwischen den Längswänden eine dem Grundträger zugeordnete Abstützstrebe für die Arme angeordnet ist. Die Arme werden vorteilhafterweise bei einem Verschieben der Nutsteine in den Aufnahmenuten entlang der Abstützstrebe geführt, wodurch ein Verkanten der Nutsteine in den Aufnahmenuten verhindert wird. Vorzugsweise begrenzt die Abstützstrebe die Aufnahmenuten. Bevorzugt wird die Abstützstrebe während des Strangpressens des Grundträgers mit hergestellt.

Insbesondere ist mindestens eine Klemmsicherung zur insbesondere in Richtung der Längserstreckungen der Aufnahmenuten wirkenden Fixierung der relativen Position von Bügelträger und Grundträger zueinander vorgesehen. Mittels der Klemmsicherung wird also der Bügelträger fest am Grundträger gehalten und ein Verschieben der Nutsteine in den Aufnahmenuten verhindert. Auch wird mittels der Klemmsicherung verhindert, dass die Nutsteine aus den Aufnahmenuten herausrutschen beziehungsweise - bei einer Ausbildung der Aufnahmenut als Einhakaufnahmenut - durch Lösen des Hintergriffs aushaken können.

Gemäß einer bevorzugten Weiterbildung der Erfindung ist vorgesehen, dass die Klemmsicherung mindestens eine in eine Gewindebohrung des Grundträgers eingeschraubte und sich am Bügelträger abstützende Klemmschraube und/oder mindestens eine in eine Gewindebohrung des Bügelträgers eingeschraubte und sich am Grundträger abstützende Klemmschraube aufweist. Durch die Klemmschraube wird eine quer zur Einschieberichtung (beziehungsweise Längserstreckung der Aufnahmenuten) und/oder Einsteckrichtung (bezüglich der Einhakaufnahmenut) auf den Bügelträger wirkende Klemmkraft erzeugt, wodurch dieser relativ zum Grundträger festgelegt wird.

Ferner ist gemäß einer Weiterbildung der Erfindung vorgesehen, dass die Klemmsicherung mindestens eine Fixierschraube aufweist, die mit ihrem Gewinde in einen Schraubkanal eingeschraubt ist, der zwischen einem Arm und einem von der Grundplatte ausgehenden, mindestens eine der Aufnahmenuten bereichsweise begrenzenden Längssteg des Grundträgers ausgebildet ist. Vorzugsweise handelt es sich bei der Aufnahmenut um eine Einhakaufnahmenut. Die Fixierschraube dient dann dazu, die Nutsteine in den Aufnahmenuten in ihrer Hintergriffstellung zu fixieren. Dazu wird durch den Durchmesser der Fixierschraube eine Kraft auf mindestens einen der Arme ausgeübt, sodass die Nutsteine in ihre Hintergriffsstellung gedrängt werden. Die Fixierschraube verhindert einerseits, dass sich die Nutsteine entlang der Längserstreckung der Aufnahmenuten verschieben und andererseits, dass sich der Hintergriff löst und die Nutsteine aus der Längsöffnung der jeweiligen Aufnahmenut herausrutschen. Der Schraubkanal kann durch eine an dem Längssteg des Grundträgers vorgesehene Zahnung und eine an dem Arm vorgesehene Zahnung gebildet sein, sodass insgesamt eine Art Innengewinde für die Fixierschraube vorliegt. Alternativ kann es sich auch um eine selbstschneidende Fixierschraube handeln, die eine Gewindezahnung im Schraubkanal selbst erzeugt.

Die Zeichnungen veranschaulichen die Erfindung anhand eines Ausführungsbeispiels und zwar zeigt:
Figur 1 eine perspektivische Darstellung eines Solarmodulhalters gemäß einem nicht erfindungsgemäßen Ausführungsbeispiel,
Figur 2 einen Querschnitt durch den Solarmodulhalter der Figur 1 mit Modultragschiene,
Figur 3 eine perspektivische Darstellung eines Solarmodulhalters gemäß einem erfindungsgemäßen Ausführungsbeispiel, in einer ersten Stellung,
Figur 4 einen Querschnitt durch den Solarmodulhalter der Figur 3 in einer zweiten Stellung,
Figur 5 eine Draufsicht des Solarmodulhalters der Figur 3,
Figur 6 eine perspektivische Ansicht eines teilweise dargestellten Solarmodulhalters gemäß einem nicht erfindungsgemäßen Ausführungsbeispiel,
Figur 7 einen Querschnitt durch den Solarmodulhalter der Figur 6,
Figur 8 eine perspektivische Ansicht eines teilweise dargestellten Solarmodulhalters gemäß einem nicht erfindungsgemäßen Ausführungsbeispiel, und
Figur 9 einen Querschnitt durch den Solarmodulhalter der Figur 8.

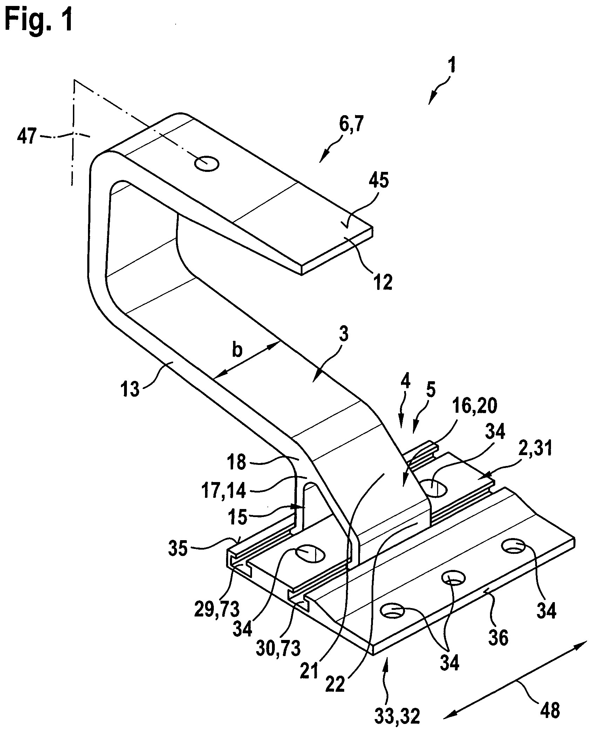

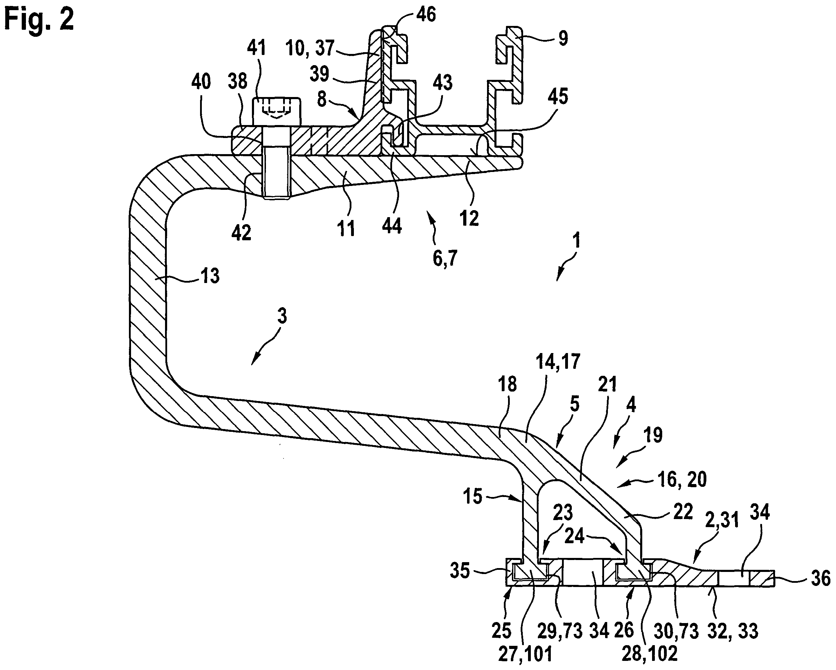

Die Figur 1 zeigt einen Solarmodulhalter 1 gemäß einem nicht erfindungsgemäßen Ausführungsbeispiel, der einen Grundträger 2 und einen Bügelträger 3 aufweist. Der Bügelträger 3 weist einen Befestigungsbereich 4 auf, mit dem er an den Grundträger 2 lösbar befestigt ist. Der Befestigungsbereich 4 gehört einem ersten Endbereich 5 des Bügelträgers 3 an. Der Bügelträger 3 weist einen zweiten Endbereich 6 auf, der einen Modulhaltebereich 7 bildet. Der Modulhaltebereich 7 besitzt einen Klemmhalter 8 (Figur 2) für eine Modultragschiene 9. Der Klemmhalter 8 besitzt ein erstes Klemmhalterteil 10, das nur in der Figur 2, nicht jedoch in der Figur 1 dargestellt ist. Ein zum Klemmhalter 8 gehörendes zweites Klemmhalterteil 11 wird von einem Endstück 12 des Bügelträgers 3 gebildet.

Der Bügelträger 3 besitzt einen Bügelmittelbereich 13, der im Wesentlichen U-förmig gestaltet ist und der dazu dient, eine Dacheindeckung, beispielsweise eine Dachpfanne zu umgreifen, derart, dass der Befestigungsbereich 4 unterhalb der Dacheindeckung und der Modulhaltebereich 7 oberhalb der Dacheindeckung liegt. Der Befestigungsbereich 4 weist einen Verzweigungsbereich 14 auf, von dem zwei Arme 15 und 16 ausgehen. Der Verzweigungsbereich ist V-förmig gestaltet, bildet also einen V-Verzweigungsbereich 17. Der Verzweigungsbereich 14 ist mit einer Abbiegung 18 des Bügelmittelbereichs 13 einstückig verbunden. Auch die Arme 15 und 16 sind einstückig mit dem Verzweigungsbereich 14 und damit auch mit der Abbiegung 18 sowie mit dem Bügelmittelbereich 13 verbunden. Die Arme 15 und 16 bilden einen Bügelabschnitt 19 des Bügelträgers 3. Der Arm 15 weist einen geradlinigen Verlauf auf, d.h., er erstreckt sich geradlinig zwischen dem Verzweigungsbereich 14 und dem Grundträger 2. Der Arm 16 ist als Winkelarm 20 ausgebildet, der einen Armteil 21 und einen Armabschnitt 22 besitzt, die einen stumpfen Winkel einschließen. Der Armabschnitt 22 verläuft parallel zur Längserstreckung des Arms 15. Der Armteil 21 schließt mit dem Arm 15 einen spitzen Winkel ein.

Die freien Enden 23 und 24 der Arme 15 und 16 sind über Nutsteinverbindungen 25 und 26 mit dem Grundträger 2 lösbar verbunden. Die Nutsteinverbindungen 25 und 26 weisen einstückig mit den Armen 15 und 16 verbundene Nutsteine 27 und 28 auf, die in Aufnahmenuten 29 und 30 des Grundträgers 2 eingeschoben sind. Die Aufnahmenuten 29 und 30 sind als C-Profilnuten ausgestaltet. Insbesondere sind sie als Einschiebeaufnahmenuten 73 ausgebildet. Das Einschieben erfolgt in Richtung der Längserstreckung der Einschiebeaufnahmenuten 73. Die Nutsteine 27 und 28 sind als T-Nutsteine 101 und 102 ausgebildet.

Der Grundträger 2 ist als Grundplatte 31 ausgebildet. Die Unterseite 32 der Grundplatte 31 bildet eine Befestigungsebene 33. Die beiden Aufnahmenuten 29 und 30 verlaufen parallel zueinander und erstrecken sich über die gesamte Breite der Grundplatte 31, so dass ein seitliches Einschieben der Nutsteine 27 und 28 der Arme 15 und 16 ermöglicht ist. Zur Befestigung des Grundträgers 2 beziehungsweise der Grundplatte 31 weist dieser/diese mehrere Befestigungslöcher 34 auf, wobei die Anordnung derart getroffen ist, dass mehrere Befestigungslöcher 34 zwischen den Aufnahmenuten 29 und 30 liegen und somit zwischen den Armen 15 und 16. Die sich zwischen den Aufnahmenuten 29 und 30 befindenden Befestigungslöcher 34 sind bevorzugt als Langlöcher ausgebildet. Die übrigen Befestigungslöcher 34 sind als Kreislöcher gestaltet und sind reihenförmig angeordnet, wobei auch die als Langlöcher gestalteten Befestigungslöcher 34 reihenförmig zueinander angeordnet sind, wobei die beiden Lochreihen parallel zueinander und parallel zu den Aufnahmenuten 29, 30 verlaufen. Hinsichtlich der als Langlöcher ausgebildeten Befestigungslöcher 34 ist zu erwähnen, dass die Figur 1 nur zwei Befestigungslöcher 34 sichtbar werden lässt. Ein drittes, von dem Arm 16 abgedecktes Befestigungsloch 34 ist jedoch vorhanden und liegt mittig zwischen den beiden sichtbaren. Die Aufnahmenut 29 verläuft entlang eines Seitenrandes 35 der Grundplatte 31. Die Aufnahmenut 30 verläuft etwa in der Mitte der Grundplatte 31. Die kreisförmigen Befestigungslöcher 34 befinden sich in der Nähe des dem Seitenrand 35 gegenüberliegenden Seitenrandes 36.

Das erste Klemmhalterteil 10 ist als Haltewinkel 37 ausgebildet und besitzt einen ersten Schenkel 38 und einen winklig zu diesem angeordneten zweiten Schenkel 39. Der Schenkel 38 weist ein Befestigungsloch 40 auf, dass von einer Klemmschraube 41 durchgriffen wird, die in eine Gewindebohrung 42 des Bügelträgers 3 eingeschraubt ist. Der Haltewinkel 37 weist einen Klemmhaken 43 auf, der mit einem Haltehaken 44 der im Querschnitt H-förmigen Modultragschiene 9 zusammenwirkt. Beim Festziehen der Klemmschraube 41 wird der Haltewinkel 37 in Richtung auf den Bügelträger 3 bewegt, wodurch der Klemmhaken 43 den Haltehaken 44 in Richtung auf das Endstück 12 spannt, wodurch die Modultragschiene 9 festgelegt wird, die sich auf der Oberseite 45 des Endstücks 12 und vorzugsweise auch an einer Seitenwand 46 des Haltewinkels 37 abstützt.

Vorzugsweise werden am Dach mehrere Solarmodulhalter 1 mit Abstand zueinander angeordnet, die alle mit derselben Modultragschiene 9 verbunden sind. An der Modultragschiene 9 kann dann ein Solarmodul oder es können dort mehrere Solarmodule befestigt werden.

Gemäß Figur 1 weist der Solarmodulhalter 1 beziehungsweise der Bügelträger 3 eine Bügelmittelebene 47 auf. Die Schnittdarstellung der Figur 2 liegt in dieser Bügelmittelebene 47. Es ist erkennbar, dass die die von der Unterseite 32 der Grundplatte 31 gebildete Befestigungsebene 33 rechtwinklig auf der Bügelmittelebene 47 steht, wobei die Längserstreckungen der Aufnahmenuten 29 und 30 (Pfeil 48) parallel zu der Befestigungsebene 33 verlaufen und rechtwinklig zu der Bügelmittelebene 47 liegen.

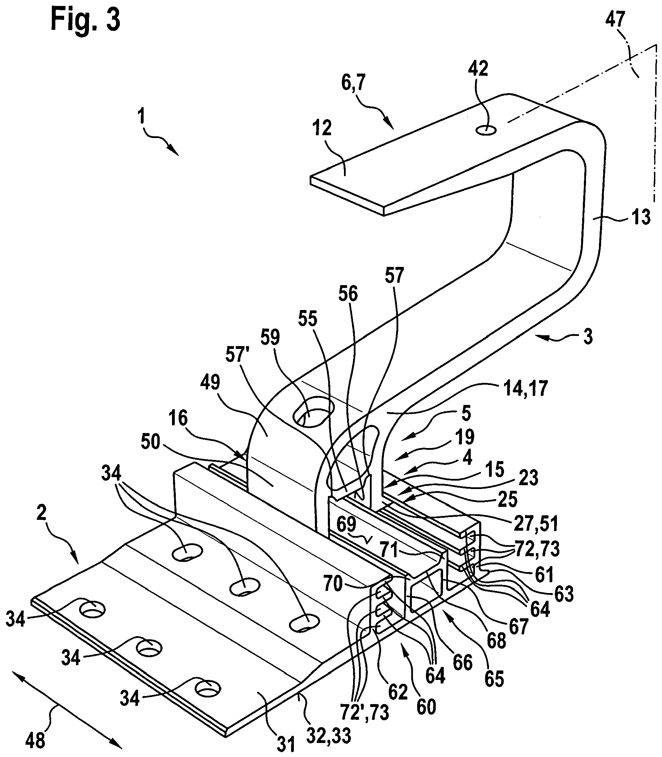

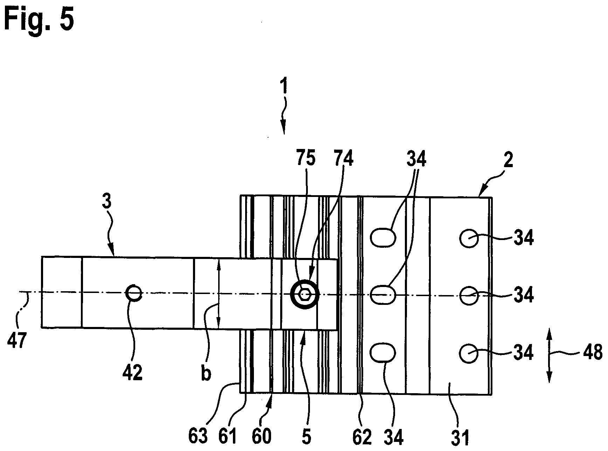

Den Figuren 1 und 2 ist zu entnehmen, dass die beiden Arme 15 und 16 in der Bügelmittelebene 47 liegen. Der Bügelträger 3 weist eine Bügelbreite b auf, die überall gleich groß, also konstant, ist, dies sowohl im Bereich des Endstücks 12, im Bügelmittelbereich 13, im Bereich der Abbiegung 18, im Verzweigungsbereich 14 sowie in den Armen 15 und 16 und auch in den Bereichen der Nutsteine 27 und 28, sodass sich letztere über die gesamte Bügelbreite b erstrecken. Der Figur 1 ist zu entnehmen, dass die Breite der Grundplatte 31 größer ist als die Breite des Bügelträgers 3, sodass der Bügelträger 3 entlang der Längserstreckung der Aufnahmenuten 29 und 30 (Pfeil 48) verschoben werden kann. Zur Einstückigkeit des Bügelträgers 3 ist noch zu sagen, dass der Bügelmittelbereich 13 einstückig in den zweiten Endbereich 6 und damit auch in das Endstück 12 übergeht. Bei der Montage des erfindungsgemäßen Solarmodulhalters 1 wird wie folgt vorgegangen: Zunächst wird der Grundträger 2 am Dach, insbesondere an einem Dachsparren, einer Pfette und/oder Latte, befestigt, indem mindestens ein Befestigungsmittel in ein Befestigungsloch 34 der zwischen den Armen 15, 16 liegenden Lochreihe eingeschraubt wird. Zusätzlich kann mindestens ein weiteres Befestigungsmittel in eines der anderen Befestigungslöcher 34, insbesondere ein Befestigungsloch 34 der anderen Lochreihe, eingebracht werden. Anschließend wird dem Grundträger 2 der Bügelträger 3 zugeordnet, in dem die Nutsteine 27 und 28 in die Aufnahmenuten 29 und 30 eingeschoben werden, wobei darauf geachtet wird, dass der Bügelmittelbereich 13 eine Dacheindeckung, beispielsweise einen Dachziegel, umgreift. Damit kommt der Modulhaltebereich 7 oberhalb des Dachziegels zu liegen, sodass dort die Modultragschiene 9 durch Klemmbefestigung gehalten werden kann. An der Modultragschiene 9 wird dann mindestens ein Solarmodul befestigt. Die Figuren 3 bis 5 zeigen einen Solarmodulhalter 1 gemäß einem erfindungsgemäßen Ausführungsbeispiel. Dieser Solarmodulhalter 1 ist ähnlich ausgebildet wie der Solarmodulhalter 1 gemäß dem Ausführungsbeispiel der Figuren 1 und 2, sodass insofern auf die Beschreibung zu den Figuren 1 und 2 verwiesen wird und im Folgenden lediglich auf die Unterschiede eingegangen wird. Zwar ist in den Figuren 3 bis 5 der Klemmhalter 8 nicht dargestellt, jedoch ist natürlich auch hier der Klemmhalter 8 - wie dieser in Figur 2 dargestellt ist - vorgesehen.

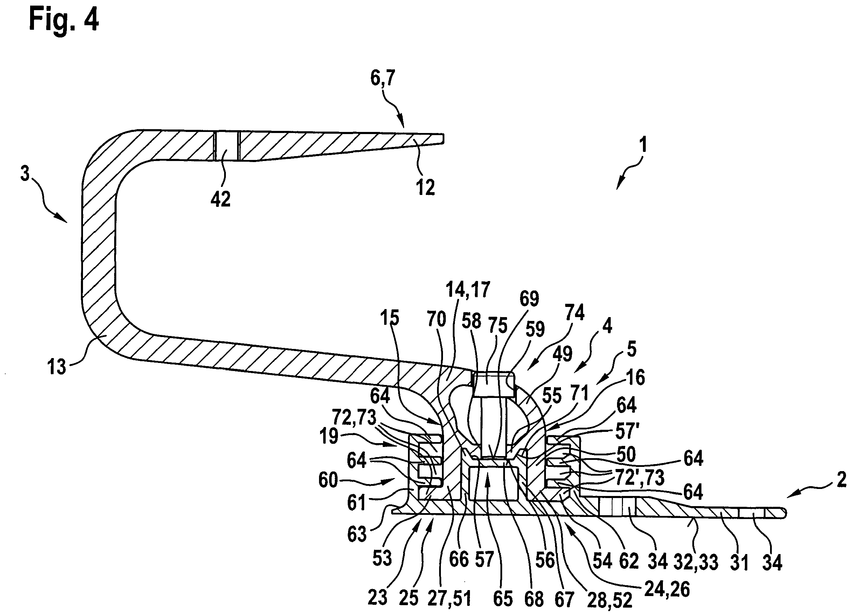

Der Arm 15 weist einen im Wesentlichen geradlinigen Verlauf auf, das heißt er erstreckt sich geradlinig zwischen dem Verzweigungsbereich 14 und dem Grundträger 2. Lediglich in der Nähe des Verzweigungsbereichs 14 weist er eine Krümmung auf. Der Arm 16 weist - ausgehend vom Verzweigungsbereich 14 - einen gekrümmten Armabschnitt 49 und einen daran anschließenden geradlinig verlaufenden Armabschnitt 50 auf. Der geradlinig verlaufende Armabschnitt 50 des Arms 16 verläuft parallel zu dem geradlinigen Bereich des Arms 15. Die an den freien Enden 23 und 24 der Arme 15 und 16 vorgesehenen Nutsteine 27 und 28 (Figur 4) sind als L-Nutsteine 51 und 52 ausgebildet. Die L-Nutsteine 51 und 52 weisen jeweils einen rechtwinklig von dem jeweiligen Arm 15, 16 ausgehenden Nutsteinsteg 53, 54 auf, wobei die Nutsteinstege 53 und 54 von den Armen 15 und 16 in entgegengesetzte Richtungen wegragen und voneinander weg weisen. Zwischen den Armen 15 und 16 ist ein die Arme 15 und 16 verbindender Verbindungssteg 55 vorgesehen, der einstückig mit den Armen 15 und 16 ausgebildet ist. Der Verbindungssteg 55 ist auf etwa halber Höhe der Arme 15 und 16 vorgesehen. Der Verbindungssteg 55 weist an seiner den freien Enden 23 und 24 der Arme 15 und 16 zugewandten Unterseite 56 zwei parallel verlaufende Längskerben 57 und 57' auf. Jeweils eine Seite der Längskerben 57 und 57' ist von einem der Arme 15, 16 begrenzt. In dem Verbindungssteg 55 ist außerdem eine Gewindebohrung 58 vorgesehen. Die Gewindebohrung 58 ist insbesondere mittig in dem Verbindungssteg 55 vorgesehen. Im Arm 16 ist in dessen gekrümmten Armabschnitt 49 eine Öffnung 59 vorgesehen. Die Öffnung 59 fluchtet mit der Gewindebohrung 58.

Der Grundträger 2 weist eine Grundplatte 31 auf. Auf der Grundplatte 31 ist eine Halterung 60 vorgesehen. Die Halterung 60 weist zwei unter einem rechten Winkel von der Grundplatte 31 wegragende, parallel verlaufende Längswände 61 und 62 auf. Die eine Längswand 61 ist an einem Längsrand 63 der Grundplatte 31 angeordnet und die andere Längswand 62 ist in etwa mittig auf der Grundplatte 31 angeordnet. Von den Längswänden 61 und 62 ragen jeweils drei Querwände 64 rechtwinklig weg. Die Querwände 64 ragen von der jeweiligen Längswand 61, 62 in Richtung der anderen Längswand 62, 61 weg. Der Abstand zwischen der Grundplatte 31 und der nächsten Querwand 64 sowie der Abstand zwischen benachbarten Querwänden 64 von einer Längswand 61, 62 ist stets gleich groß. Zwischen den Längswänden 61 und 62 ist auf der Grundplatte 31 eine Abstützstrebe 65 des Grundträgers 2 angeordnet. Die Abstützstrebe 65 weist zwei rechtwinklig von der Grundplatte 31 wegragende und parallel zu den Längswänden 61 und 62 verlaufende Seitenwände 66 und 67 sowie eine die Seitenwände 66 und 67 an ihren freien Enden verbindende Deckenwand 68 auf. An der Oberseite 69 der Deckenwand 68 sind in deren Randbereichen zwei parallel zueinander verlaufende Längsvorsprünge 70 und 71 ausgebildet, die in die Längskerben 57 und 57' des Verbindungsstegs 55 eingreifen können.

Durch die Grundplatte 31, die Längswände 61 und 62 und die Querwände 64 werden als Einschiebeaufnahmenuten 73 ausgebildete Aufnahmenuten 72 und 72' begrenzt. Jeder Längswand 61 beziehungsweise 62 sind also drei Aufnahmenuten 72 beziehungsweise 72' zugeordnet, die unterschiedliche Höhenabstände zur Grundplatte 31 aufweisen. Zwischen den freien Enden der Querwände 64 und den Seitenwänden 66 und 67 der Abstützstrebe 65 ist jeweils ein Freiraum ausgebildet. Die Aufnahmenuten 72 und 72' und die Freiräume sind derart dimensioniert, dass die L-Nutsteine 51 und 52 in jeweils eine der Aufnahmenuten 72, 72' eingreifen können und dass die L-Nutsteine 51 und 52 in der jeweiligen Aufnahmenut 72, 72' und die Arme 15 und 16 in den Freiräumen verschieblich (in Richtung der Längserstreckung der Aufnahmenuten72 und 72') gehalten sind.

Ferner ist eine Klemmsicherung 74 vorgesehen. Die Klemmsicherung 74 weist eine Klemmschraube 75 auf, die - im montiertem Zustand des Solarmodulhalters 1 gemäß Figur 4 - die im Arm 16 vorgesehene Öffnung 59 durchgreift und in die Gewindebohrung 58 des Verbindungsstegs 55 eingeschraubt ist und sich an der Deckenwand 68 abstützt.

In der Grundplatte 31 sind außerhalb der Halterung 60, das heißt außerhalb des zwischen den Längswänden 61 und 62 liegenden Bereichs, die Befestigungslöcher 34 vorgesehen. Dabei bilden jeweils drei Befestigungslöcher 34 eine Lochreihe, die parallel zu der Längserstreckung (Pfeil 48) der Aufnahmenuten 72 und 72' verläuft. Dabei sind die Befestigungslöcher 34 der einen Lochreihe als Kreislöcher und die Befestigungslöcher 34 der anderen Lochreihe als Langlöcher ausgebildet. Die Längsachse der Langlöcher verläuft quer, insbesondere rechtwinklig, zu den Aufnahmenuten 72 und 72'.

Hinsichtlich der Montage des Solarmodulhalters 1 gemäß den Figuren 3 bis 5 wird auf das zu den Figuren 1 und 2 beschriebene Vorgehen verwiesen. In Abweichung zu diesem, werden bei der Zuordnung des Bügelträgers 3 zum Grundträger 2 die Nutsteine 27 und 28 jeweils in eine Aufnahmenut 72, 72' eingeschoben. Dabei werden - je nach den Gegebenheiten auf dem Dach - zwei geeignete Aufnahmenuten 72 und 72' mit einem bestimmten Höhenabstand zur Grundplatte 31 gewählt, sodass der Bügelträger 3 die Dacheindeckung umgreifen kann. Die Figur 3 zeigt den Solarmodulhalter 1 in einer Stellung, in der die Nutsteine 27 und 28 in den zwei obersten Aufnahmenuten 72 und 72' angeordnet sind; die Figur 4 zeigt den Solarmodulhalter 1 in einer Stellung, in der die Nutsteine 27 und 28 in den zwei untersten Aufnahmenuten 72 und 72' angeordnet sind. Der Bügelträger 3 wird dann entlang der Einschieberichtung (Pfeil 48) bis in eine gewünschte Position verlagert. In dieser Position wird er mittels der Klemmschraube 75 fixiert, indem die Klemmschraube 75, die vorzugsweise bereits teilweise in die Gewindebohrung 58 des Verbindungsstegs 55 eingeschraubt war, weiter eingeschraubt wird, sodass das Ende der Klemmschraube 75 gegen die Deckenwand 68 der Abstützstrebe 65 gedrängt wird. Dadurch wird eine in Richtung der Längserstreckung der Klemmschraube 75 wirkende Kraft auf die Arme 15 und 16 ausgeübt, sodass die Nutsteine 27 und 28 in den zugehörigen Aufnahmenuten 72 und 72' kraftschlüssig gehalten sind beziehungsweise in diesen verkeilen.

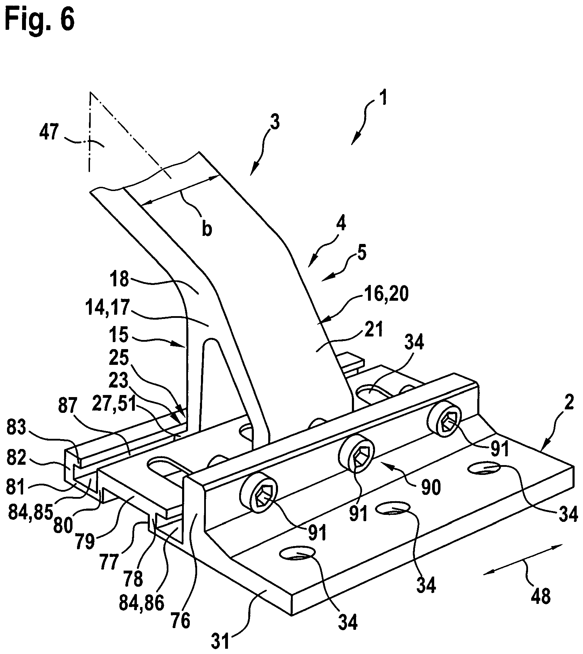

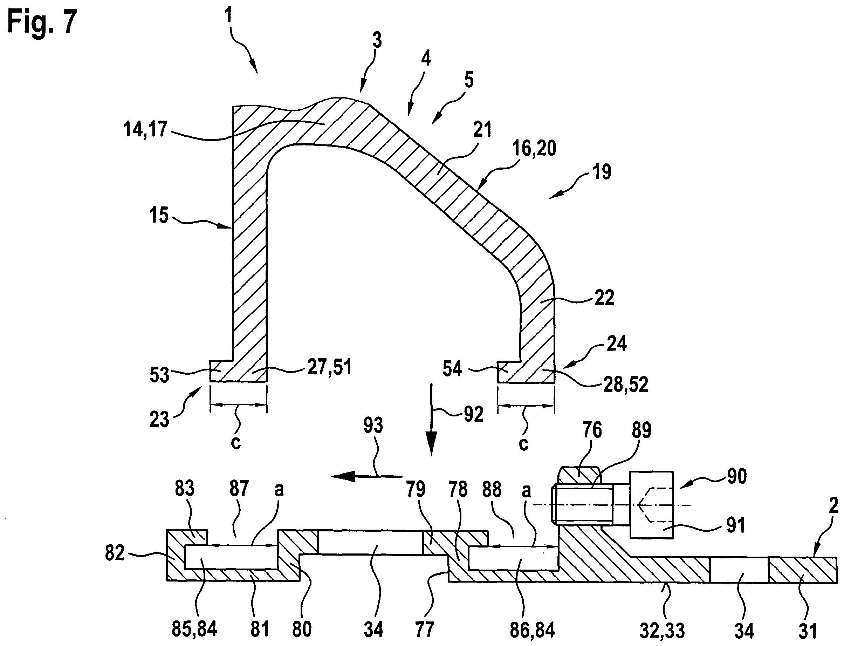

Die Figuren 6 und 7 zeigen einen Solarmodulhalter 1 gemäß einem nicht erfindungsgemäßen Ausführungsbeispiel. Die Figur 6 zeigt den Solarmodulhalter 1 im demontierten und die Figur 7 im montierten Zustand. Dabei ist jeweils lediglich der Grundträger 2 und ein Bereich des Bügelträgers 3, insbesondere dessen Befestigungsbereich 4, zu erkennen. Der Solarmodulhalter 1 gemäß den Figuren 6 und 7 ist im Wesentlichen gemäß den Figuren 1 und 2 ausgebildet, sodass auf diese Figuren und die entsprechende Beschreibung verwiesen wird und im Folgenden lediglich die Unterschiede erläutert werden.

Ähnlich wie bei dem Ausführungsbeispiel der Figuren 3 bis 5 sind die Nutsteine 27 und 28 der Arme 15 und 16 als L-Nutsteine 51 und 52 ausgebildet, indem jeweils ein Nutsteinsteg 53, 54 rechtwinklig von dem zugehörigen Arm 15, 16 wegragt. Dabei ragen die Nutsteinstege 53 und 54 in die gleiche Richtung weg.

Der Grundträger 2 weist eine Grundplatte 31 auf. Auf der Grundplatte 31 ist ein rechtwinklig von dieser wegragender Längssteg 76 vorgesehen. An einem Seitenrand 77 der Grundplatte 31 ragt parallel zu dem Längssteg 76 eine Strebe 78 weg. An diese Strebe 78 schließt eine Zwischenplatte 79 an, die bereichsweise parallel zu der Grundplatte 31 und bereichsweise in paralleler Verlängerung zu der Grundplatte 31 verläuft. Die Zwischenplatte 79 schließt mittels einer rechtwinklig zu dieser verlaufenden Strebe 80 an eine Grundplattenverlängerung 81 an, die in der Ebene der Grundplatte 31 verläuft und somit mit der Grundplatte 31 die Befestigungsebene 33 aufspannt. Die Grundplattenverlängerung 81 geht mittels einer rechtwinklig von dieser wegragenden Strebe 82 in einen parallel zur Grundplattenverlängerung 81 verlaufenden Steg 83 über. Der Steg 83 und die Zwischenplatte 79 liegen in einer Ebene. Durch die Zwischenplatte 79, die Strebe 80, die Grundplattenverlängerung 81, die Strebe 82 und den Steg 83 beziehungsweise durch den Längssteg 76, die Grundplatte 31, die Strebe 78 und die Zwischenplatte 79 wird jeweils eine als Einhakaufnahmenut 84 ausgebildete Aufnahmenut 85 beziehungsweise 86 begrenzt. Die Aufnahmenuten 85 und 86 weisen jeweils eine Längsöffnung 87, 88 auf, die zwischen dem Steg 83 und der Zwischenplatte 79 beziehungsweise der Zwischenplatte 79 und dem Längssteg 76 ausgebildet ist. Die Breite a der Längsöffnungen 87 und 88 ist größer als die Breite c der L-Nutsteine 51 und 52.

In dem Längssteg 76 des Grundträgers 2 sind drei Gewindebohrungen 89 vorgesehen. Die Längsachse der Gewindebohrungen 89 verläuft parallel zur Grundplatte 31. Der Abstand benachbarter Gewindeschrauben ist vorzugsweise kleiner als die Bügelbreite b des Bügelträgers 3. In die Gewindebohrungen 89 ist jeweils eine Klemmschraube 91 eingeschraubt. Im montierten Zustand des Solarmodulhalters 1 (Figur 6) stützt sich eine der Klemmschrauben 91 mit ihrem freien Ende am Arm 16, insbesondere an dessen Armabschnitt 22, ab. Die Gewindebohrungen 89 und die Klemmschrauben 91 bilden eine Klemmsicherung 90.

Der Grundträger 2 weist sechs Befestigungslöcher 34 auf. Drei der Befestigungslöcher 34 sind als Langlöcher ausgebildet und in der Zwischenplatte 79 vorgesehen. Die Längsachse der Langlöcher verläuft quer, insbesondere rechtwinklig, zu den Aufnahmenuten 85 und 86. Die drei weiteren Befestigungslöcher 34 sind in der Grundplatte 31 mit Abstand zur Aufnahmenut 86 vorgesehen und als Kreislöcher ausgebildet.

Bei der Montage des Solarmodulhalters 1 werden nach der Befestigung des Grundträgers 2 am Dach die Nutsteine 27 und 28 durch die Längsöffnungen 87 und 88 in die Aufnahmenuten 85 und 86 entlang der durch den Pfeil 92 gekennzeichneten Richtung eingesteckt. Die Nutsteine 27 und 28 werden kann in Richtung des Pfeils 93 in der jeweiligen Aufnahmenut 85, 86 verlagert, sodass ein Hintergriff erzielt wird. Auch kann eine Verschiebung des Bügelträgers 3 in Richtung der Längserstreckung der Aufnahmenuten 85 und 86 (Pfeil 48) erfolgen, um eine gewünschte Position des Bügelträgers 1 relativ zum Grundträger 2 und somit zum Dach einzustellen. Diese Position wird dann mittels einer der Klemmschrauben 91 fixiert, indem die Klemmschraube 91 weiter in die Gewindebohrung 89 eingeschraubt und dadurch mit ihrem freien Ende gegen den Arm 16 gedrängt wird.

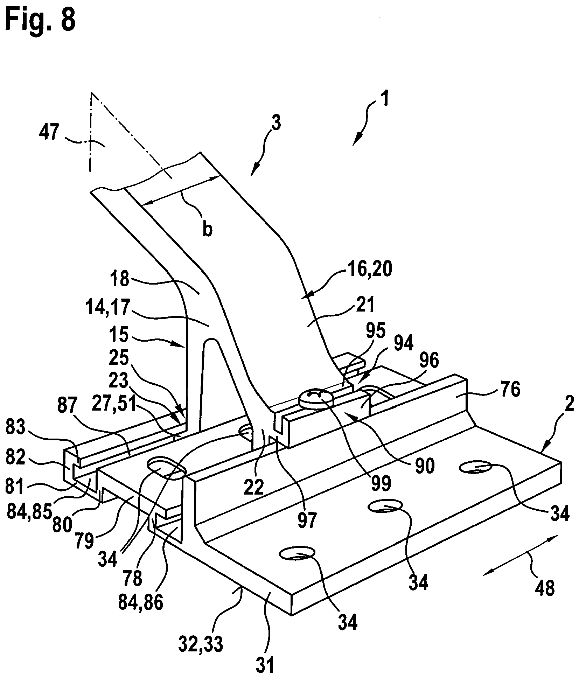

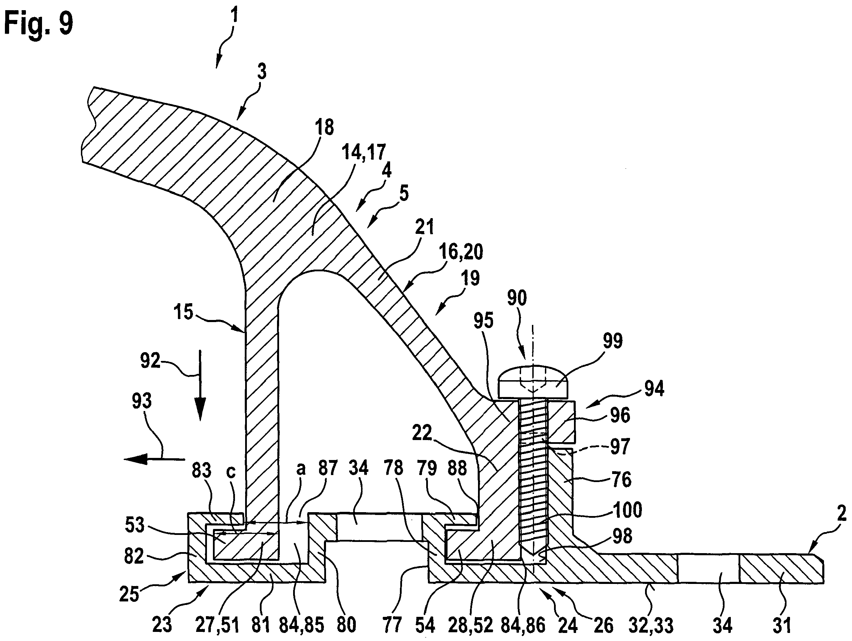

Das nicht erfindungsgemäße Ausführungsbeispiel, gemäß den Figuren 8 und 9 entspricht im Wesentlichen dem Ausführungsbeispiel der Figuren 6 und 7, sodass insofern auf die Beschreibung zu den Figuren 6 und 7 verwiesen wird und im Folgenden lediglich die Unterschiede zu den Figuren 6 und 7 erläutert werden.

Am Arm 16 des Bügelträgers 3 ist an dessen Übergangsbereich von dem Armteil 21 in den Armabschnitt 22 ein sich über die Bügelbreite b erstreckende U-förmige U-Halterung 94 vorgesehen. Die U-Halterung weist zwei Schenkel 95 und 96 und einen die Schenkel 95 und 96 verbindenden Boden 97 auf. Der eine Schenkel 95 ist einstückig mit dem Arm 16 ausgebildet. Im Boden 97 ist eine nicht zu erkennende Öffnung vorgesehen.

Eine Seite des Längsstegs 76 des Grundträgers 2 und eine dieser gegenüberliegende Seite des Armabschnitts 22 des Arms 16 bilden einen Schraubkanal 98 für eine Fixierschraube 99 der Klemmsicherung 90. Die Fixierschraube 99 durchgreift - im montierten Zustand des Solarmodulhalters 1 - die Öffnung des Bodens 97 und ist mit ihrem Gewinde 100 in den Schraubkanal 98 eingeschraubt. Der Schraubkanal 98 kann durch eine Zahnung, die an den sich gegenüberliegenden Seiten des Armabschnitts 22 und des Längsstegs 76 vorgesehen ist, oder durch Einschrauben der Fixierschraube 99 gebildet werden, die in letzterem Fall als selbstschneidende Fixierschraube ausgebildet ist.

Die Montage des Solarmodulhalters 1 der Figuren 8 und 9 erfolgt im Wesentlichen gemäß der Montage des Solarmodulhalters 1 gemäß den Figuren 6 und 7. Vorzugsweise ist die Fixierschraube 99 mit ihrem Gewinde 100 anfänglich zwischen die Schenkel 95 und 96 eingeschraubt, sodass diese unverlierbar am Bügelträger 3 gehalten ist und somit nach erfolgtem Positionieren des Bügelträgers 3 am Grundträger 2 zur Fixierung in den Schraubkanal 98 eingeschraubt werden kann.

## Patentansprüche

1. Solarmodulhalter (1) mit einem insbesondere an einem Dach befestigbaren Grundträger (2) und einem Bügelträger (3) zum Halten einer Modultragschiene (9), wobei der Bügelträger (3) einen Befestigungsbereich (4) aufweist, der mit dem Grundträger (2) lösbar verbunden ist, wobei der Befestigungsbereich (4) von einem mehrere Arme (15,16) aufweisenden Bügelabschnitt (19) des Bügelträgers (3) gebildet ist, wobei jeder Arm (15, 16) des Bügelabschnitts (19) mit dem Grundträger (2) lösbar verbunden ist, wobei der Bügelträger (3) einen Bügelmittelbereich (13) aufweist, der einstückig in einen Verzweigungsbereich (14) übergeht, der wiederum einstückig in die Arme (15,16) übergeht, wobei der Grundträger (2) als Grundplatte (31) ausgebildet ist oder eine Grundplatte (31) aufweist, **dadurch gekennzeichnet, dass** die freien Enden (23,24) der Arme (15,16) über Nutsteinverbindungen (25,26) mit dem Grundträger (2) verbunden sind, wobei die Nutsteinverbindungen (25,26) jeweils einen am freien Ende (23,24) des jeweiligen Arms (15,16) vorgesehenen Nutstein (27,28) und mindestens eine am Grundträger (2) vorgesehene Aufnahmenut (29,30,72,72',85,86) für den Nutstein (27,28) aufweisen, und dass für jeden Nutstein (27,28) mehrere Aufnahmenuten (29,30,72,72',85,86) am Grundträger (2) vorgesehen sind, die unterschiedliche Höhenabstände zur Ebene der Grundplatte (31) aufweisen.

2. Solarmodulhalter nach Anspruch 1, **dadurch gekennzeichnet, dass** der Befestigungsbereich (4) einem ersten Endbereich (5) des Bügelträgers (3) angehört.

3. Solarmodulhalter nach einem der vorhergehenden Ansprüche, **dadurch gekennzeichnet, dass** die Längserstreckungen der Arme (15,16) zumindest abschnittsweise einen spitzen Winkel einschließen.

4. Solarmodulhalter nach einem der vorhergehenden Ansprüche, **dadurch gekennzeichnet, dass** zumindest einer der Arme (15,16) ein Winkelarm (20) ist.

5. Solarmodulhalter nach einem der vorhergehenden Ansprüche, **dadurch gekennzeichnet, dass** der Grundträger (2) mindestens ein Befestigungsloch (34) aufweist, das zwischen den Armen (15,16) oder außerhalb eines zwischen den Armen (15,16) liegenden Bereichs des Grundträgers (2) liegt.

6. Solarmodulhalter nach einem der vorhergehenden Ansprüche, **dadurch gekennzeichnet, dass** der Bügelträger (3) eine Bügelmittelebene (47) aufspannt, wobei die Arme (15,16) in der Bügelmittelebene (47) liegen.

7. Solarmodulhalter nach einem der vorhergehenden Ansprüche, **dadurch gekennzeichnet, dass** der Bügelträger (3) eine Bügelbreite (b) aufweist, die über den gesamten Bügelträgerlängsverlauf konstant oder etwa konstant ist.

8. Solarmodulhalter nach einem der vorhergehenden Ansprüche, **dadurch gekennzeichnet, dass** der Bügelträger (3) einen Modulhaltebereich (7) aufweist, der einen zweiten Endbereich (6) des Bügelträgers (3) bildet.

9. Solarmodulhalter nach Anspruch 8, **dadurch gekennzeichnet, dass** der Modulhaltebereich (7) einen Klemmhalter (8) für die Modultragschiene (9) aufweist.

10. Solarmodulhalter nach einem der vorhergehenden Ansprüche, **dadurch gekennzeichnet, dass** zumindest einer der Arme (15,16) geradlinig verläuft und rechtwinklig zu der Ebene der Grundplatte (31) steht.

11. Solarmodulhalter nach einem der Ansprüche 4 bis 10, **dadurch gekennzeichnet, dass** der Winkelarm (20) einen Armabschnitt (22) aufweist, der rechtwinklig zur Ebene der Grundplatte (31) steht.

12. Solarmodulhalter nach Anspruch 11, **dadurch gekennzeichnet, dass** der Armabschnitt (22) über eine der Nutsteinverbindungen (25,26) mit dem Grundträger (2) verbunden ist.

13. Solarmodulhalter nach einem der vorhergehenden Ansprüche, **dadurch gekennzeichnet, dass** der Bügelmittelbereich (13) eine Abbiegung (18) aufweist, an die der Verzweigungsbereich (14) unmittelbar anschließt.

14. Solarmodulhalter nach einem der vorhergehenden Ansprüche, **dadurch gekennzeichnet, dass** die Nutsteinverbindungen (25,26) als Verschiebeverbindungen ausgebildet sind.

15. Solarmodulhalter nach einem der vorhergehenden Ansprüche, **dadurch gekennzeichnet, dass** die Aufnahmenut (29,30,72,72',85,86) eine Längserstreckung (48) aufweist, entlang der der Nutstein (27,28) in die Aufnahmenut (29,30,72,72',85,86) einschiebbar und in der Aufnahmenut (29,30,72,72',85,86) verschiebbar angeordnet ist.

16. Solarmodulhalter nach einem der vorhergehenden Ansprüche, **dadurch gekennzeichnet, dass** der Nutstein (27,28) als L-Nutstein (51,52) oder T-Nutstein (101,102) ausgebildet ist.

17. Solarmodulhalter nach einem der vorhergehenden Ansprüche, **dadurch gekennzeichnet, dass** die Aufnahmenut (29,30,72,72',85,86) als Einschiebeaufnahmenut (73) oder Einhakaufnahmenut (84) ausgebildet ist.

18. Solarmodulhalter nach einem der vorhergehenden Ansprüche, **dadurch gekennzeichnet, dass** die Grundplatte (31) eine Halterung (60) aufweist, wobei die mehreren Aufnahmenuten (29,30,72,72',85,86) übereinander angeordnet an der Halterung (60) vorgesehen sind.

19. Solarmodulhalter nach Anspruch 18, **dadurch gekennzeichnet, dass** die Halterung (60) zwei rechtwinklig von der Grundplatte (31) wegragende, zueinander parallele Längswände (61,62) mit jeweils mehreren Querwänden (64) aufweist, wobei zwischen der Grundplatte (31) und zwei der Querwände (64) sowie zwischen den weiteren Querwänden (64) die Aufnahmenuten (29,30,72,72',85,86) ausgebildet sind.

20. Solarmodulhalter nach Anspruch 19, **dadurch gekennzeichnet, dass** zwischen den Längswänden (61,62) eine dem Grundträger (2) zugeordnete Abstützstrebe (65) für die Arme (15,16) angeordnet ist.

21. Solarmodulhalter nach einem der vorhergehenden Ansprüche, **gekennzeichnet durch** mindestens eine Klemmsicherung (74,90) zur insbesondere in Richtung der Längserstreckungen der Aufnahmenuten (29,30,72,72',85,86) wirkenden Fixierung der relativen Position von Bügelträger (3) und Grundträger (2) zueinander.

22. Solarmodulhalter nach Anspruch 21, **dadurch gekennzeichnet, dass** die Klemmsicherung (74,90) mindestens eine in eine Gewindebohrung (89) des Grundträgers (2) eingeschraubte und sich am Bügelträger (3) abstützende Klemmschraube (91) und/oder mindestens eine in eine Gewindebohrung (58) des Bügelträgers (3) eingeschraubte und sich am Grundträger (2) abstützende Klemmschraube (75) aufweist.

23. Solarmodulhalter nach Anspruch 21, **dadurch gekennzeichnet, dass** die Klemmsicherung (74,90) mindestens eine Fixierschraube (99) aufweist, die mit ihrem Gewinde (100) in einen Schraubkanal (98) eingeschraubt ist, der zwischen einem Arm (15,16) und einem von der Grundplatte (31) ausgehenden, mindestens eine der Aufnahmenuten (29,30,72,72',85,86) bereichsweise begrenzenden Längssteg (76) des Grundträgers (2) ausgebildet ist.

## Claims

1. A solar module bracket (1) having a base support (2) which is fastenable in particular on a roof and a yoke support (3) for holding a module support rail (9), wherein the yoke support (3) comprises a fastening region (4) which is releasably connected to the base support (2), wherein the fastening region (4) is formed by a yoke portion (19) of the yoke support (3) which comprises several arms (15, 16), each arm (15, 16) of the yoke portion (19) is releasably connected to the base support (2), the yoke support (3) comprises a yoke centre region (13) which merges integrally into a branching region (14) which, in turn merges integrally into the arms (15, 16), wherein the base support (2) is realized as a base plate (31) or comprises a base plate (31), **characterized in that** the free ends (23, 24) of the arms (15, 16) are connected to the base support (2) by means of slot nut connections (25, 26), wherein the slot nut connections (25, 26) comprise in each case a slot nut (27, 28) which is provided on the free end (23, 24) of the respective arm (15, 16) and at least one receiving groove (29, 30, 72, 72', 85, 86) which is provided on the base support (2) for the slot nut (27, 28), and that several receiving grooves (29, 30, 72, 72', 85, 86), which comprise different height distances to the plane of the base plate (31), are provided on the base support (2) for each slot nut (27, 28).

2. The solar module bracket according to claim 1, **characterized in that** the fastening region (4) is associated with a first end region (5) of the yoke support (3).

3. The solar module bracket according to one of the preceding claims, **characterized in that** the longitudinal extensions of the arms (15, 16) enclose at least in portions an acute angle.

4. The solar module bracket according to one of the preceding claims, **characterized in that** at least one of the arms (15, 16) is an angled arm (20).

5. The solar module bracket according to one of the preceding claims, **characterized in that** the base support (2) comprises at least one fastening hole (34) which lies between the arms (15, 16) or outside a region of the base support (2) which lies between the arms (15, 16).

6. The solar module bracket according to one of the preceding claims, **characterized in that** the yoke support (3) spans a yoke centre plane (47), wherein the arms (15, 16) lie in the yoke centre plane (47).

7. The solar module bracket according to one of the preceding claims, **characterized in that** the yoke support (3) comprises a yoke width (b) which is constant or approximately constant over the entire longitudinal development of the yoke support.

8. The solar module bracket according to one of the preceding claims, **characterized in that** the yoke support (3) comprises a module holding region (7) which forms a second end region (6) of the yoke support (3).

9. The solar module bracket according to claim 8, **characterized in that** the module holding region (7) comprises a clamping holder (8) for the module support rail (9).

10. The solar module bracket according to one of the preceding claims, **characterized in that** at least one of the arms (15, 16) extends in a straight line and is oriented in a perpendicular manner with respect to the plane of the base plate (31).

11. The solar module bracket according to one of claims 4 to 10, **characterized in that** the angled arm (20) comprises an arm portion (22) which is oriented in a perpendicular manner with respect to the plane of the base plate (31).

12. The solar module bracket according to claim 11, **characterized in that** the arm portion (22) is connected to the base support (2) by means of one of the slot nut connections (25, 26).

13. The solar module bracket according to one of the preceding claims, **characterized in that** the yoke centre region (13) comprises a bending (18) to which the branching region (14) connects in a direct manner.

14. The solar module bracket according to one of the preceding claims, **characterized in that** the slot nut connections (25, 26) are realized as sliding connections.

15. The solar module bracket according to one of the preceding claims, **characterized in that** the receiving groove (29, 30, 72, 72', 85, 86) comprises a longitudinal extension (48) along which the slot nut (27, 28) is insertable into the receiving groove (29, 30, 72, 72', 85, 86) and arranged slidable in the receiving groove (29, 30, 72, 72', 85, 86).

16. The solar module bracket according to one of the preceding claims, **characterized in that** the slot nut (27, 28) is realized as an L-slot nut (51, 52) or a T-slot nut (101, 102).

17. The solar module bracket according to one of the preceding claims, **characterized in that** the receiving groove (29, 30, 72, 72', 85, 86) is realized as an insertion receiving groove (73) or a hook-in receiving groove (84).

18. The solar module bracket according to one of the preceding claims, **characterized in that** the base plate (31) comprises a holder (60), wherein the several receiving grooves (29, 30, 72, 72', 85, 86) are provided arranged one above another on the holder (60).

19. The solar module bracket according to claim 18, **characterized in that** the holder (60) comprises two longitudinal walls (61, 62), which project away from the base plate (31) in a perpendicular manner and are parallel to one another, with in each case several cross walls (64), wherein the receiving grooves (29, 30, 72, 72', 85, 86) are realized between the base plate (31) and two of the cross walls (64) as well as between the further cross walls (64).

20. The solar module bracket according to claim 19, **characterized in that** a support strut (65), which is associated with the base support (2), for the arms (15, 16) is arranged between the longitudinal walls (61, 62).

21. The solar module bracket according to one of the preceding claims, **characterized by** at least one clamping safety device (74, 90) for fixation of the relative position of the yoke support (3) and the base support (2) with respect to one another, the fixation in particular acting in the direction of the longitudinal extensions of the receiving grooves (29, 30, 72, 72', 85, 86).

22. The solar module bracket according to claim 21, **characterized in that** the clamping safety device (74, 90) comprises at least one clamping screw (91) which is screwed into a threaded bore (89) of the base support (2) and is supported on the yoke support (3) and/or at least one clamping screw (75) which is screwed into a threaded bore (58) of the yoke support (3) and is supported on the base support (2).

23. The solar module bracket according to claim 21, **characterized in that** the clamping safety device (74, 90) comprises at least one locating screw (99) which, by way of its thread (100), is screwed into a screw channel (98) which is realized between an arm (15, 16) and a longitudinal web (76) of the base support (2) which proceeds from the base plate (31) and borders at least one of the receiving grooves (29, 30, 72, 72', 85, 86) in regions.

## Revendications

1. Dispositif de fixation de module solaire (1) avec un support de base (2) pouvant notamment être fixé à un toit et un support d'arceau (3) pour le maintien d'un rail porteur de module (9), dans lequel le support d'arceau (3) présente une région de fixation (4) qui est connectée de manière amovible au support de base (2), dans lequel la région de fixation (4) est formée d'une section d'arceau (19) du support d'arceau (3) présentant plusieurs bras (15, 16), dans lequel chaque bras (15, 16) de la section d'arceau (19) est connecté de manière amovible au support de base (2), dans lequel le support d'arceau (3) présente une région centrale d'arceau (13) qui se transforme d'une pièce en une région de ramification (14) qui se transforme de nouveau d'une pièce en les bras (15, 16), dans lequel le support de base (2) est réalisé en tant que plaque de base (31) ou présente une plaque de base (31), **caractérisé en ce que** les extrémités libres (23, 24) des bras (15, 16) sont connectées par le biais de connexions à coulisseau (25, 26) au support de base (2), dans lequel les connexions à coulisseau (25, 26) présentent chacune un coulisseau (27, 28) prévu à l'extrémité libre (23, 24) du bras respectif (15, 16) et au moins une rainure de réception (29, 30, 72, 72', 85, 86) pour le coulisseau (27, 28) prévue sur le support de base (2), et que plusieurs rainures de réception (29, 30, 72, 72', 85, 86) sont prévues sur le support de base (2) pour chaque coulisseau (27, 28), lesquelles présentent différents écarts de hauteur par rapport au plan de la plaque de base (31).

2. Dispositif de fixation de module solaire selon la revendication 1, **caractérisé en ce que** la région de fixation (4) appartient à une première région d'extrémité (5) du support d'arceau (3).

3. Dispositif de fixation de module solaire selon une des revendications précédentes, **caractérisé en ce que** les prolongements longitudinaux des bras (15, 16) incluent au moins par sections un angle aigu.

4. Dispositif de fixation de module solaire selon une des revendications précédentes, **caractérisé en ce qu'**au moins un des bras (15, 16) est un bras angulaire (20).

5. Dispositif de fixation de module solaire selon une des revendications précédentes, **caractérisé en ce que** le support de base (2) présente au moins un orifice de fixation (34) qui se situe entre les bras (15, 16) ou en dehors d'une région du support de base (2) située entre les bras (15, 16).

6. Dispositif de fixation de module solaire selon une des revendications précédentes, **caractérisé en ce que** le support d'arceau (3) déploie un plan central d'arceau (47), dans lequel les bras (15, 16) se situent dans le plan central d'arceau (47).

7. Dispositif de fixation de module solaire selon une des revendications précédentes, **caractérisé en ce que** le support d'arceau (3) présente une largeur d'arceau (b) qui est constante ou approximativement constante sur le tracé longitudinal entier du support d'arceau.

8. Dispositif de fixation de module solaire selon une des revendications précédentes, **caractérisé en ce que** le support d'arceau (3) présente une région de maintien de module (7) qui forme une seconde région d'extrémité (6) du support d'arceau (3).

9. Dispositif de fixation de module solaire selon la revendication 8, **caractérisé en ce que** la région de maintien de module (7) présente un support de serrage (8) pour le rail porteur de module (9).

10. Dispositif de fixation de module solaire selon une des revendications précédentes, **caractérisé en ce qu'**au moins un des bras (15, 16) s'étend en ligne droite et se trouve à angle droit par rapport au plan de la plaque de base (31).

11. Dispositif de fixation de module solaire selon une des revendications 4 à 10, **caractérisé en ce que** le bras angulaire (20) présente une section de bras (22) qui se trouve à angle droit par rapport au plan de la plaque de base (31).

12. Dispositif de fixation de module solaire selon la revendication 11, **caractérisé en ce que** la section de bras (22) est connectée par le biais d'une des connexions à coulisseau (25, 26) au support de base (2).

13. Dispositif de fixation de module solaire selon une des revendications précédentes, **caractérisé en ce que** la région centrale d'arceau (13) présente une courbure (18) à laquelle la région de ramification (14) se rattache directement.

14. Dispositif de fixation de module solaire selon une des revendications précédentes, **caractérisé en ce que** les connexions à coulisseau (25, 26) sont réalisées en tant que connexions coulissantes.

15. Dispositif de fixation de module solaire selon une des revendications précédentes, **caractérisé en ce que** la rainure de réception (29, 30, 72, 72', 85, 86) présente un prolongement longitudinal (48) le long duquel le coulisseau (27, 28) peut être inséré dans la rainure de réception (29, 30, 72, 72', 85, 86) et est disposé de manière coulissante dans la rainure de réception (29, 30, 72, 72', 85, 86).

16. Dispositif de fixation de module solaire selon une des revendications précédentes, **caractérisé en ce que** le coulisseau (27, 28) est réalisé en tant que coulisseau en L (51, 52) ou coulisseau en T (101, 102).

17. Dispositif de fixation de module solaire selon une des revendications précédentes, **caractérisé en ce que** la rainure de réception (29, 30, 72, 72', 85, 86) est réalisée en tant que rainure de réception par insertion (73) ou rainure de réception par accrochage (84).

18. Dispositif de fixation de module solaire selon une des revendications précédentes, **caractérisé en ce que** la plaque de base (31) présente une fixation (60), dans lequel les nombreuses rainures de réception (29, 30, 72, 72', 85, 86) sont prévues sur la fixation (60) en étant disposées les unes au-dessus des autres.

19. Dispositif de fixation de module solaire selon la revendication 18, **caractérisé en ce que** la fixation (60) présente deux parois longitudinales (61, 62) parallèles l'une à l'autre, faisant saillie à angle droit à l'écart de la plaque de base (31), avec chacune plusieurs parois transversales (64), dans lequel les rainures de réception (29, 30, 72, 72', 85, 86) sont réalisées entre la plaque de base (31) et deux des parois transversales (64) ainsi qu'entre les autres parois transversales (64).

20. Dispositif de fixation de module solaire selon la revendication 19, **caractérisé en ce qu'**un étai d'appui (65) pour les bras (15, 16) associé au support de base (2) est disposé entre les parois longitudinales (61, 62).

21. Dispositif de fixation de module solaire selon une des revendications précédentes, **caractérisé par** au moins une sécurité à serrage (74, 90) pour la fixation de la position relative du support d'arceau (3) et du support de base (2) l'un par rapport à l'autre, agissant notamment en direction des prolongements longitudinaux des rainures de réception (29, 30, 72, 72', 85, 86).

22. Dispositif de fixation de module solaire selon la revendication 21, **caractérisé en ce que** la sécurité à serrage (74, 90) présente au moins une vis de serrage (91) vissée dans un alésage fileté (89) du support de base (2) et s'appuyant sur le support d'arceau (3) et/ou au moins une vis de serrage (75) vissée dans un alésage fileté (58) du support d'arceau (3) et s'appuyant sur le support de base (2).

23. Dispositif de fixation de module solaire selon la revendication 21, **caractérisé en ce que** la sécurité à serrage (74, 90) présente au moins une vis de fixation (99) qui est vissée avec son filetage (100) dans un canal de vis (98) qui est réalisé entre un bras (15, 16) et une traverse longitudinale (76) du support de base (2) partant de la plaque de base (31), limitant par régions au moins une des rainures de réception (29, 30, 72, 72', 85, 86).
